# EUROPÄISCHE PATENTSCHRIFT

(11) **EP 1 464 972 B1**
(45) Veröffentlichungstag und Bekanntmachung des Hinweises auf die Patenterteilung: **28.12.2011**
(21) Anmeldenummer: 04005277.1
(22) Anmeldetag: 05.03.2004
(51) Int. Cl.: G01R 31/327, H02H 3/04, H02J 3/00

(54) **Verfahren zum Prüfen einer Anordnung elektrischer Geräte**
Method for testing an arrangement of electrical apparatus
Procédé de test d'un agencement d'appareils électriques

(30) Priorität: 03.04.2003 DE 10315240
(43) Veröffentlichungstag der Anmeldung: 06.10.2004
(73) Patentinhaber: SIEMENS AKTIENGESELLSCHAFT, 80333 München (DE)
(72) Erfinder: Berger, Tanja, 91334 Hemhofen (DE); Fruth, Wolfgang, 91052 Erlangen (DE)

(56) Entgegenhaltungen:
- EP-A- 0 828 329
- WO-A-01/69751
- WO-A-01/71880
- US-A- 4 245 318
- US-A1- 2002 004 715
- US-B1- 6 535 370

## Beschreibung

Verfahren zum Prüfen einer Anordnung elektrischer Geräte

Die vorliegende Erfindung betrifft ein Verfahren zur Prüf einer Anordnung elektrischer Geräte gemäβ dem Oberbegriff des Auspruchs 1.

Ein Prüfverfahren ist beispielsweise aus der WO-A-01/71880 bekannt. Bei dem bekannten Verfahren werden Leitungsquerschnitte, über welche die Speisebausteine, die Schutzschalter und die Verbraucher miteinander verbunden sind, auf korrekte Dimensionierung geprüft und eventuell sogar optimiert. Siehe auch WO-A- 01/69751 und US-B-6,535,370.

Bei der Planung und Projektierung elektrischer Versorgungsnetze sind außer der korrekten Dimensionierung weitere Bedingungen einzuhalten. Beispielsweise ist der Projekteur unter anderem gehalten, die Schutzschalter auf ihr selektives Verhalten zueinander zu untersuchen. Unter Selektivität ist dabei das Verhalten der Schutzschalter bei Überstrom und Kurzschluss zu verstehen. Üblicherweise soll nur der dem Fehler in Energieflussrichtung gesehen nächstliegende vorgeordnete Schutzschalter abschalten. Ist dies im gesamten zu überprüfenden Strombereich der Fall, spricht man von Vollselektivität. Verhält sich ein Schutzschalter nur innerhalb eines begrenzten Strombereiches selektiv zu allen seinen vorgeordneten Schutzschaltern, so spricht man von Teilselektivität.

Insbesondere ist weiter aus der US 4,245, 318 A eine Schalteranordnung bekannt, bei der die Schalter selektiv zusammengeschaltet sind, d. h. das der näher am Verbraucher angeordnete Schalter jeweils eher auslöst. Das Auslöseverhalten der Schalter ist in Form von Auslösezeit-Kurven, welche bei stationären Strömen aufgenommen wurden, als Funktion des durch den jeweiligen Schutzschalter fließenden Stroms vorgegeben. Ein Rechner prüft anhand dieser Auslösezeit-Kurven, ob die Anordnung die gewünschte Selektivität aufweist.

Im Stand der Technik sind keine rechnergestützten Prüfverfahren bekannt, mittels derer automatisch eine umfassende Überprüfung einer Anordnung elektrischer Geräte auf deren Selektivität ohne weiteres durchführbar ist, wobei umfassend hier unter Berücksichtigung des Auslöseverhaltens im Falle eines Kurzschlusses, also auch für sehr kurze Auslösezeiten, meint.

Die Aufgabe der Erfindung ist es, ein derartiges Prüfverfahren zu schaffen.

Die Aufgabe wird bei einem gattungsgemäßen Prüfverfahren durch die Merkmale des kennzeichnenden Teils des Anspruchs 1 gelöst. In diesem Fall ist anhand des Auslöseverhaltens das Kurzschlussverhalten mit Auslösezeiten zwischen 0,1 und 1 s sowie das Kurzschlussschnellauslöseverhalten mit Auslösezeiten unter 0,1 s ermittelbar.

Vorteile und Einzelheiten ergeben sich aus der nachfolgenden Beschreibung eines Ausführungsbeispiels in Verbindung mit den Zeichnungen. Dabei zeigen in Prinzipdarstellung
- FIG 1: schematisch ein Beispiel einer Anordnung elektrischer Geräte,
- FIG 2: den Aufbau eines Rechners,
- FIG 3: ein mögliches Ablaufdiagramm,
- FIG 4: ein Beispiel einer vordefinierten Beschreibung,
- FIG 5: ein typisches Auslöseverhalten eines Schutzschalters,
- FIG 6: ein weiteres Ablaufdiagramm,
- FIG 7: ein Strom-Zeit-Diagramm und
- FIG 8: ein erfindungsgemäßes Ablaufdiagramm.

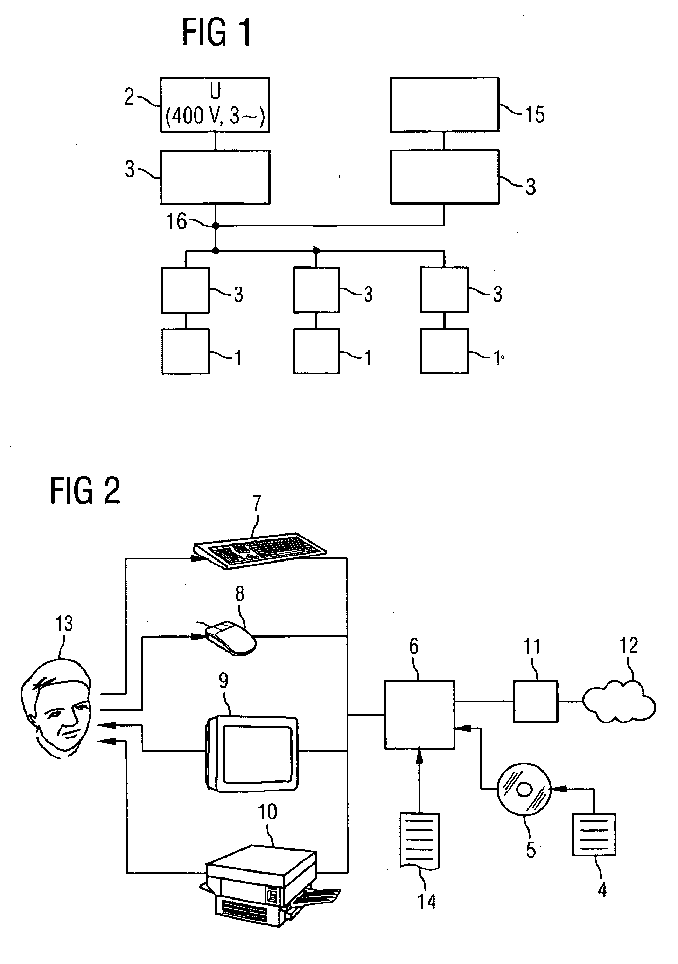

Gemäß FIG 1 weist eine Anordnung elektrischer Geräte beispielsweise mehrere Verbraucher 1 auf, die von einem ersten Speisebaustein 2 aus mit elektrischer Energie versorgt werden. Zwischen den Verbrauchern 1 und dem ersten Speisebaustein 2 sind dabei jeweils mindestens zwei Schutzschalter 3 angeordnet, die zueinander in Reihe geschaltet sind. Gemäß FIG 1 erfolgt dabei eine Versorgung mit einer (Dreiphasen-) Wechselspannung U mit z. B. 400 V und 50 oder 60 Hz, also einer Periodendauer von 20 bzw. 16,6 ms. Auch eine Gleichspannungsversorgung wäre möglich, fiele jedoch nicht in den beanspruchten Bereich.

Die in FIG 1 dargestellte Anordnung soll darauf überprüft werden, ob die Schutzschalter 3 derart ausgelegt sind, dass sie selektiv sind. Es soll also überprüft werden, ob bei einem Fehlerfall (Kurzschluss und/oder Überlast) stets derjenige Schutzschalter 3 auslöst, der zwischen dem ersten Speisebaustein 2 und dem Fehlerort liegt, wobei zwischen dem Fehlerort und dem auslösenden Schutzschalter 3 kein weiterer Schutzschalter 3 angeordnet sein soll.

Hierzu ist gemäß FIG 2 ein Rechner mit einem Computerprogramm 4 programmiert, das auf einem Datenträger 5, z. B. einer CD-ROM 5, in (ausschließlich) maschinenlesbarer Form gespeichert ist.

Der Rechner weist die üblichen Komponenten auf. Es sind dies ein Rechnerkern 6, Eingabeeinrichtungen 7, 8 (typisch eine Tastatur 7 und eine Maus 8), Ausgabeeinrichtungen 9, 10 (typisch eine Bildschirmeinheit 9 und ein Drucker 10) sowie gegebenenfalls eine Schnittstelle 11 zu einem Rechnernetz 12, z. B. dem Internet.

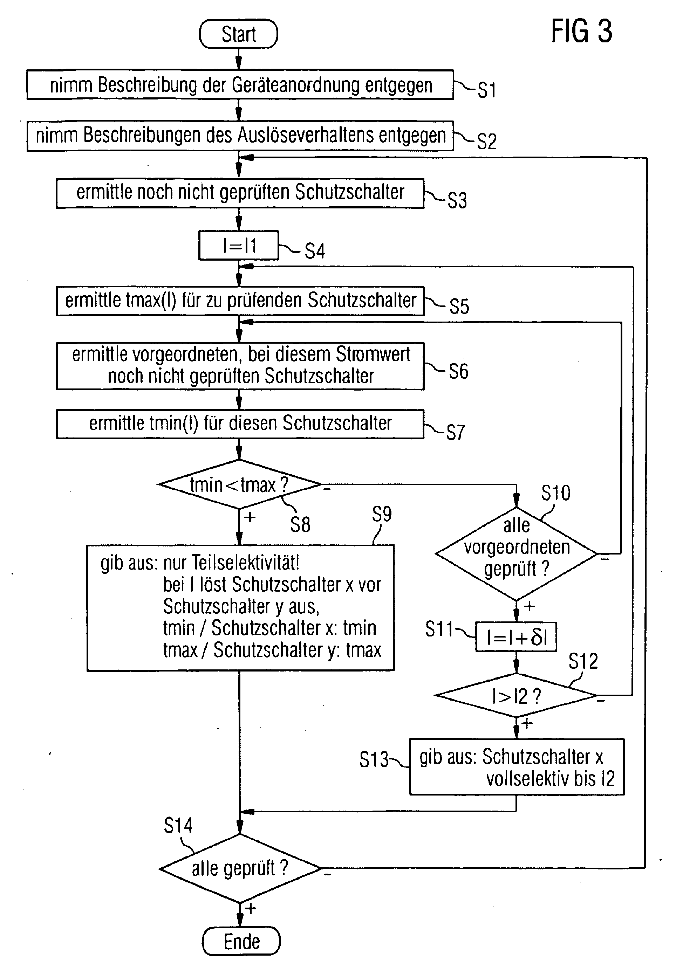

Auf Grund der Programmierung mit dem Computerprogramm 4 führt der Rechner ein Prüfverfahren für die Anordnung elektrischer Geräte aus, das nachfolgend in Verbindung mit FIG 3 näher beschrieben wird.

Gemäß FIG 3 wird dem Rechner von einem Anwender 13 in einem Schritt S1 zunächst die Geräteanordnung als solche vorgegeben. Sodann werden vom Anwender 13 in einem Schritt S2 die einzelnen Geräte der Geräteanordnung, also die Verbraucher 1, der erste Speisebaustein 2 und die Schutzschalter 3, näher spezifiziert. Hierzu kann insbesondere vom Rechner auf einen Katalog 14 zugegriffen werden, in dem vordefinierte Beschreibungen von Verbrauchern 1, Speisebausteinen 2 und Schutzschaltern 3 enthalten sind. Die Eigenschaften der Geräte der Geräteanordnung können dem Rechner somit durch Auswahl vordefinierter Beschreibungen vorgegeben werden.

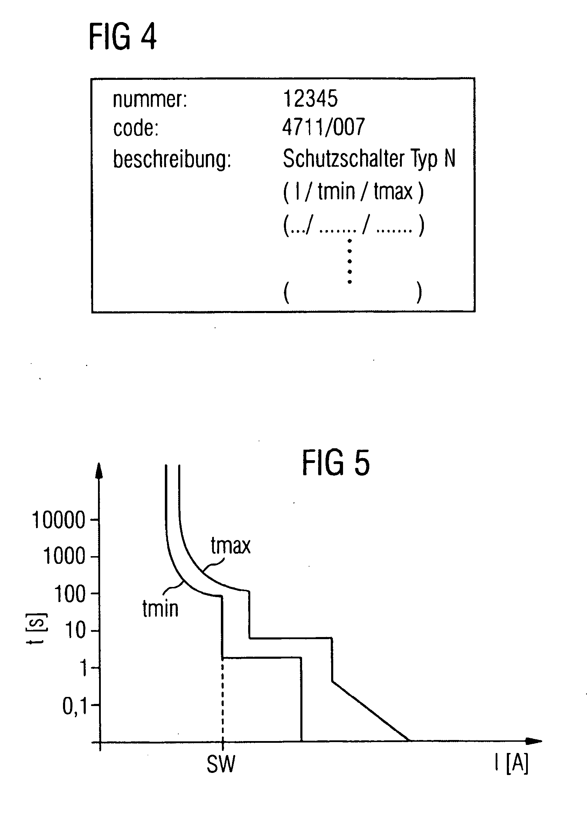

FIG 4 zeigt beispielhaft eine derartige vordefinierte Beschreibung für einen Schutzschalter 3. Gemäß FIG 4 enthält die Beschreibung zunächst eine Ordnungsnummer, die nur für die interne Verwaltung der Beschreibung innerhalb der Katalogdatei 14 relevant ist. Sodann enthält die Beschreibung auch einen Code, der eindeutig für das beschriebene Gerät ist, beispielsweise eine maschinenlesbare Fabrikatebezeichnung (MLFB). Sodann enthält die Beschreibung eine Angabe, aus der ersichtlich ist, dass es sich bei dem beschriebenen Gerät um einen Schutzschalter vom Typ N handelt. Schließlich enthält die Beschreibung noch eine Beschreibung des Auslöseverhaltens des Schutzschalters 3. Gemäß FIG 4 kann sie beispielsweise für eine Anzahl von den Schutzschalter 3 durchfließenden Stromwerten I jeweils die minimale Auslösezeit tmin und die maximale Auslesezeit tmax enthalten, nach der der Schutzschalter 3 jeweils auslöst. Es sind aber auch andere Arten der Beschreibung denkbar.

Anhand der Beschreibungen des Auslöseverhaltens sind somit - beispielsweise durch lineare oder nicht lineare Interpolation - vom Rechner für jeden Schutzschalter 3 bei jedem Stromwert I die minimale und die maximale Auslösezeit tmin, tmax ermittelbar.

Ein Beispiel eines derart ermittelbaren Auslöseverhaltens ist in FIG 5 dargestellt. Nach rechts ist dabei der Stromwert I in Ampere, nach oben die Zeit in Sekunden aufgetragen. Aus FIG 5 ist dabei insbesondere ersichtlich, dass vom Rechner bei hinreichend großen Stromwerten I anhand der Beschreibungen Auslösezeiten tmin, tmax ermittelbar sind, die vom Bereich etlicher Minuten bis unter einer Sekunde reichen.

Zum eigentlichen Überprüfen des Selektivitätsverhaltens wird zunächst in einem Schritt S3 ein noch ungeprüfter Schutzschalter 3 ermittelt. Ferner wird in einem Schritt S4 der Stromwert I auf einen Anfangswert 11 gesetzt. Der Anfangswert I1 kann dabei fest vorgegeben sein. Es ist aber auch möglich, dass der Anfangswert I1 dem Rechner vom Anwender 13 vorgegeben wird oder dass der Rechner den Anfangswert I1 anhand der Auslegung der Geräteanordnung selbsttätig ermittelt.

In einem Schritt S5 ermittelt der Rechner sodann für den zu prüfenden Schutzschalter 3 die maximale Auslösezeit tmax für den Strom I. Sodann ermittelt er in einem Schritt S6 einen Schutzschalter 3, der dem zu prüfenden Schutzschalter 3 vorgeordnet ist und bei dem momentanen Stromwert I noch nicht mit dem zu prüfenden Schutzschalter 3 verglichen wurde. Für diesen vorgeordneten Schutzschalter 3 ermittelt der Rechner dann in einem Schritt S7 die korrespondierende minimale Auslesezeit tmin bei diesem Stromwert I. Dabei wird für beide Schutzschalter 3 berücksichtigt, um welchen Typ (z. B. Überlastauslöser, zeitverzögerter oder unverzögerter Kurzschlussauslöser, Erdschlussauslöser) und um welchen Fehlerfall (Überlast, dreipoliger Kurzschluss, einpoliger Kurzschluss usw.) es sich handelt.

In einem Schritt S8 vergleicht der Rechner die ermittelte maximale Auslösezeit tmax des zu prüfenden Schutzschalters 3 mit der ermittelten minimalen Auslösezeit tmin des momentan herangezogenen vorgeordneten Schutzschalters 3.

Wenn die minimale Auslösezeit tmin des vorgeordneten Schutzschalters 3 kleiner als die maximale Auslösezeit tmax des zu prüfenden Schutzschalters 3 ist, ist der zu prüfende Schutzschalter 3 bei diesem Stromwert I nicht selektiv. Es wird daher in einem Schritt S9 eine Meldung an den Anwender 13 ausgegeben. Die Meldung enthält zunächst die Information, dass nur teilselektives Verhalten vorliegt. Ferner enthält sie die Aussage, welcher vorgeordnete Schutzschalter 3 vor dem zu prüfenden Schutzschalter 3 auslöst. Schließlich enthält die Meldung den Stromwert I, bei dem dieser Fall auftritt, sowie die minimale Auslösezeit tmin des vorgeordneten Schutzschalters 3 und die maximale Auslösezeit tmax des zu prüfenden Schutzschalters 3.

Wenn hingegen die maximale Auslösezeit tmax des zu prüfenden Schutzschalters 3 kleiner als die minimale Auslösezeit tmin des momentan herangezogenen vorgeordneten Schutzschalters 3 ist, wird zu einem Schritt S10 verzweigt. Dort wird überprüft, ob bereits alle dem zu prüfenden Schutzschalter 3 vorgeordneten Schutzschalter bei diesem Stromwert I überprüft wurden. Wenn dies noch nicht der Fall war, wird zum Schritt S6 gesprungen. Anderenfalls wird mit einem Schritt S11 fortgefahren.

Im Schritt S11 wird der Stromwert I um einen Änderungswert δI erhöht. Nach dem Erhöhen des Stromwertes I wird in einem Schritt S12 geprüft, ob der Stromwert I größer als ein Endwert 12 ist. Der Änderungswert δI kann - analog zum Anfangswert I1 - fest vorgegeben sein, dem Rechner vom Anwender 13 vorgegeben werden oder vom Rechner selbsttätig ermittelt werden. Auch der Endwert 12 kann alternativ fest vorgegeben sein, vom Anwender 13 vorgegeben werden oder vom Rechner selbst ermittelt werden.

Wenn der Stromwert I den Endwert 12 nicht übersteigt, wird zum Schritt S5 zurückgesprungen. Anderenfalls wird in einem Schritt S13 eine Meldung ausgegeben, dass der zu prüfende Schutzschalter 3 im gesamten Strombereich bis zum Endwert 12 stets vor allen ihm vorgeordneten Schutzschaltern 3 auslöst.

Sowohl nach Ausgabe der Meldung im Schritt S9 als auch nach Ausgabe der Meldung im Schritt S13 wird mit einem Schritt S14 fortgefahren. In diesem Schritt S14 überprüft der Rechner, ob er bereits alle Schutzschalter 3 überprüft hat. Wenn dies noch nicht der Fall ist, wird zum Schritt S3 zurückgesprungen. Anderenfalls ist das Prüfverfahren beendet.

Anhand des oben stehend ausführlich beschriebenen Prüfverfahrens prüft der Rechner also für jeden der Schutzschalter 3 bei einer Anzahl von Stromwerten I, ob er vor jedem zwischen ihm und dem ersten Speisebaustein 2 angeordneten Schutzschalter 3 auslöst.

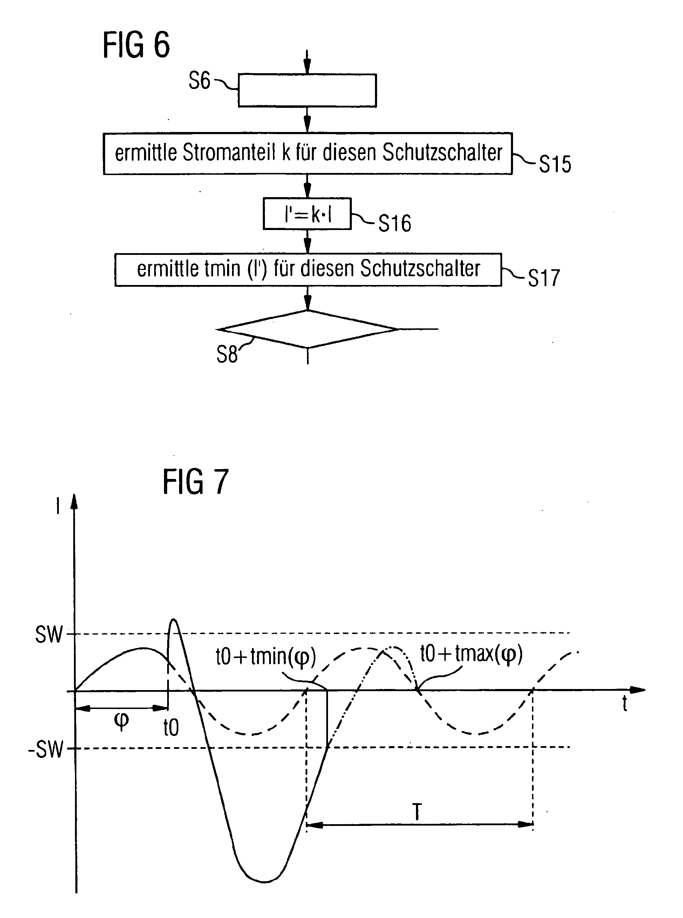

Gemäß FIG 1 ist bei der beschriebenen Geräteanordnung nicht nur ein erster Speisebaustein 2, sondern auch ein zweiter Speisebaustein 15 vorgesehen, der ebenfalls über einen Schutzschalter 3 und einen Knotenpunkt 16 mit den Verbrauchern 1 verbunden ist. In diesem Fall muss das oben stehend in Verbindung mit FIG 3 beschriebene Prüfverfahren geringfügig modifiziert werden. Dies wird nachstehend in Verbindung mit FIG 6 näher erläutert.

Gemäß FIG 6 werden anstelle des Schrittes S7 Schritte S15 bis S17 ausgeführt. Im Schritt S15 wird vom Rechner aus den Impedanzen der Speisebausteine 2, 15 und der zwischen den Speisebausteinen 2, 15 und dem Knotenpunkt 16 angeordneten Elemente (Leitungen, Schutzschalter 3) ein Stromanteil k ermittelt, der aus dem ersten Speisebaustein 2 bezogen wird. Der Stromanteil k liegt selbstverständlich zwischen Null und Eins. Im Schritt S16 wird ein korrigierter Stromwert I' ermittelt, der sich als Produkt des Anteilsfaktors k und des Stromwerts I ergibt. In Fällen, in denen der Knotenpunkt 16 zwischen dem zu prüfenden Schutzschalter 3 und dem vorgeordneten Schutzschalter 3 liegt, wird im Schritt S17 beim vorgeordnetem Schutzschalter 3 die minimale Auslösezeit tmin für den korrigierten Stromwert I' ermittelt. Die minimale Auslösezeit tmin des vorgeordneten Schutzschalters 3 wird also derart ermittelt, dass der Stromwert I dort nur anteilig berücksichtigt wird.

Das obenstehende Prinzip ist stets anwendbar, solange der Überlastbereich der Schutzschalter 3 betrachtet wird. Da im Rahmen des erfindungsgemäßen Prüfverfahrens hingegen auch das Auslöseverhalten der Schutzschalter 3 im Kurzschlussbereich erfasst und überprüft werden soll, ist die oben stehend beschriebene Vorgehensweise nur in Ausnahmefällen anwendbar. Mit einer entsprechenden erfindungsgemäßen Modifikation ist das Verfahren aber auch im Kurzschlussfall, wenn also der Stromwert I für mindestens einen der Schutzschalter 3 größer als ein für diesen Schutzschalter 3 spezifischer Schwellwert SW ist, anwendbar.

Im Kurzschlussfall wird die Auslösezeit tmin, tmax der Schutzschalter 3 im Wesentlichen durch die in der Zeit zwischen dem Auftreten des Kurzschlusses und dem Auslösen des Schutzschalters 3 vom Schutzschalter 3 aufgenommene Energie bestimmt. Diese Energie ist proportional dem Integral von I²t, wobei I der (zeitlich veränderliche) Stromwert und t die Zeit ist. Dies wird nachstehend in Verbindung mit FIG 7 näher erläutert.

In FIG 7 ist angenommen, dass zu einem Zeitpunkt t0 ein Kurzschluss auftritt, auf Grund dessen der Betrag des fließenden Stromes I den Schwellwert SW für den momentan betrachteten Schutzschalter 3 übersteigt. Der Zeitpunkt t0 weist dabei eine Phasenlage ϕ innerhalb einer Periode (der Periodendauer T) des Wechselstromes auf.

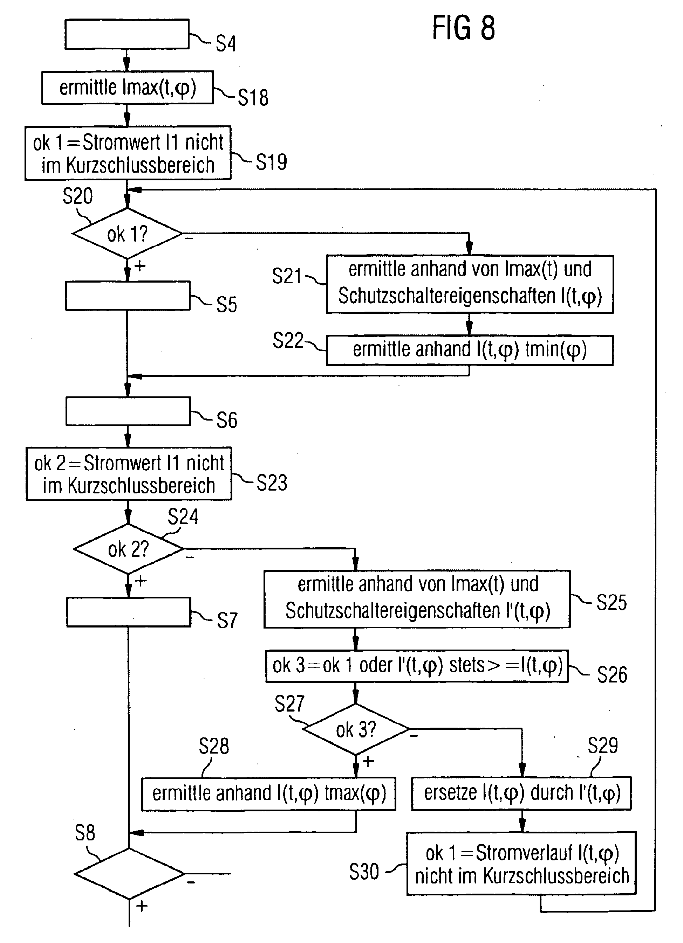

In diesem Fall wird gemäß FIG 8 vom Rechner nach dem Schritt S4 in einem Schritt S18 zunächst ein maximal möglicher Verlauf Imax des Stromwerts I ermittelt. Die Ermittlung erfolgt dabei anhand einer Beschreibung des Speisebausteins 2. Es wird also ermittelt, welchen maximalen zeitlichen Verlauf Imax des Stromwerts I der Speisebaustein 2 überhaupt liefern kann. Die Phasenlage ϕ ist dabei ein Parameter des Verlaufs Imax.

Sodann wird in Schritten S19 und S20 überprüft, ob der Stromwert I1 im Kurzschlussbereich des zu prüfenden Schutzschalters 3 liegt. Wenn dies nicht der Fall ist, wird zum Schritt S5 verzweigt. Anderenfalls wird in einem Schritt S21 anhand der Beschreibung des betreffenden Schutzschalters 3 ermittelt, welche strombegrenzenden Wirkungen der Schutzschalter 3 auf den maximal möglichen Strom Imax ausübt. Der maximal mögliche zeitliche Verlauf Imax des Stromwerts I wird daher vom Rechner im Schritt S21 auf Grund der Beschreibung des betrachteten Schutzschalters 3 auf einen (tatsächlichen) zeitlichen Verlauf des Stromwerts I reduziert. Im Ergebnis wird also der tatsächliche zeitliche Verlauf des Stromwerts I aus dem maximal möglichen zeitlichen Verlauf Imax und den Eigenschaften des Schutzschalters 3 ermittelt. Der zeitliche Verlauf des Stromwerts I wird somit vom Rechner unter Berücksichtigung der Beschreibung der Anordnung, nämlich insbesondere des Speisebausteins 2 und des Schutzschalters 3, ermittelt. Gegebenenfalls werden auch die weiteren Elemente der Anordnung, insbesondere die Leitungen, mit betrachtet.

Anhand dieses Verlaufs ermittelt der Rechner in einem Schritt S22 die minimale Auslösezeit tmin des zu prüfenden Schutzschalters 3 als Funktion der Phasenlage ϕ.

Ein möglicher derartiger Verlauf ist in FIG 7 mit einer durchgezogenen Linie dargestellt. Ab dem Zeitpunkt t0 ermittelt der Rechner anhand des ermittelten zeitlichen Verlaufs des Stromwerts I das zeitliche Integral über das Quadrat des jeweils momentan gegebenen Stromwerts I. Dieses Integral wird vom Rechner mit einem minimalen Grenzwert und einem maximalen Grenzwert verglichen. Der minimale Grenzwert und der maximale Grenzwert sind für den jeweiligen Schutzschalter 3 spezifisch. Durch den Vergleich mit dem minimalen Grenzwert kann ermittelt werden, zu welchem Zeitpunkt t0 + tmin (ϕ) der betrachtete Schutzschalter 3 bei der momentanen Phasenlage ϕ frühestens auslöst.

In analoger Weise kann der Rechner in Schritten S23 und S24 überprüfen, ob der Stromwert 11 im Kurzschlussbereich des vorgeordneten Schutzschalters 3 liegt. Wenn dies nicht der Fall ist, wird zum Schritt S7 verzweigt. Anderenfalls wird in einem Schritt S25 anhand des vorgeordneten Schutzschalters 3 ermittelt, welche strombegrenzenden Wirkungen dieser Schutzschalter 3 auf den maximal möglichen Strom Imax ausübt. Er ermittelt also einen theoretischen Stromverlauf I' als Funktion der Zeit, soweit er diesen Schutzschalter 3 betrifft.

In Schritten S26 und S27 überprüft der Rechner schließlich, ob der vorgeordnete Schutzschalter 3 den maximal möglichen Strom Imax stärker begrenzt als der eigentlich zu prüfende Schutzschalter 3. Wenn entweder der eigentlich zu prüfende Schutzschalter 3 nicht im Kurzschlussbereich ist oder aber der eigentlich zu prüfende Schutzschalter 3 der den Stromverlauf begrenzende Schutzschalter 3 ist, wird vom Schritt S27 zu einem Schritt S28 verzweigt. In diesem Schritt S28 ermittelt der Rechner durch Vergleich mit dem maximalen Grenzwert, zu welchem Zeitpunkt t0 + tmax (ϕ) der vorgeordnete Schutzschalter 3 spätestens auslöst. Vom Schritt S28 wird zum Schritt S8 gesprungen.

Wenn in den Schritten S26 und S27 erkannt wurde, dass beide Schutzschalter 3 im Kurzschlussbereich auslösen und der vorgeordnete Schutzschalter 3 der strombegrenzende Schutzschalter 3 ist, wird nicht der Schritt S28, sondern der Schritt S29 ausgeführt. Im Schritt S29 wird der Stromverlauf I(t, (ϕ), anhand dessen der zu prüfende Schutzschalter 3 zu prüfen ist, durch den neu ermittelten Stromverlauf I'(t, ϕ) ersetzt. Sodann wird in einem Schritt S30 überprüft, ob der (nunmehr verringerte) Stromverlauf I(t, ϕ) im Kurzschlussbereich des zu prüfenden Schutzschalters 3 liegt und zum Schritt S20 gesprungen.

Wie aus FIG 7 ersichtlich ist, liegen die ermittelten Auslösezeiten tmin, tmax in der Größenordnung der Periodendauer T. In aller Regel werden dabei ein Drittel einer Periodendauer T nicht unterschritten, drei Periodendauern T nicht überschritten. Meist liegen die Auslösezeiten zwischen einer und zwei Periodendauern T.

Wie aus FIG 7 ohne weiteres ersichtlich ist, ist der zeitliche Verlauf des Stromwert I von der Phasenlage ϕ des Zeitpunkts t0 abhängig. Wenn der Stromwert I oberhalb des Schwellwerts SW für den jeweils betrachteten Schutzschalter 3 liegt, wird die Phasenlage ϕ daher bei der Ermittlung des zeitlichen Verlaufs vom Rechner mit berücksichtigt.

Die Berücksichtigung des zeitlichen Verlaufs des Stromwerts I und auch die Berücksichtigung der Phasenlage ϕ ist also nur dann erforderlich, wenn der Stromwert I oberhalb des Schwellwerts SW von beiden betrachteten Schutzschalter 3 liegt. Wenn dagegen der Stromwert I für einen der Schutzschalter 3 oberhalb des Schwellwerts SW für diesen Schutzschalter 3 liegt, aber unterhalb des Schwellwerts SW des anderen Schutzschalters 3, ist für den anderen Schutzschalter 3 der zeitliche Verlauf des Stromwerts I unbeachtlich. Für diesen Schutzschalter 3 kann vielmehr die Ermittlung der Auslösezeit tmin, tmax wie oben stehend in Verbindung mit FIG 3 bzw. FIG 6 beschrieben erfolgen. Wenn hingegen der zeitliche Verlauf des Stromwerts I auch oberhalb des Schwellwerts SW des anderen Schutzschalters 3 liegt, muss der zeitliche Verlauf des Stromwerts I vom Rechner selbstverständlich auch bei der Ermittlung der Auslösezeit tmin, tmax für diesen anderen Schutzschalter 3 berücksichtigt werden, so dass auch im Schritt S8 für alle möglichen Phasenlagen ϕ ermittelt werden muss, welcher Schutzschalter 3 zuerst auslöst.

Mittels des erfindungsgemäßen Prüfverfahrens ist es auf einfache Weise möglich, die Selektivität einer Geräteanordnung automatisch und sicher zu prüfen. Auch kann diese Überprüfung ohne weiteres dokumentiert werden. Dies ist insbesondere bei größeren Gebäuden, in denen Menschenansammlungen auftreten können, von Bedeutung, da für derartige Gebäude eine zulassungsrechtliche Vorschrift besteht, dass alle Schutzschalter 3 voll selektiv sein müssen.

Das erfindungsgemäße Prüfverfahren kann für sich ausgeführt werden. Es ist aber auch möglich, es in andere Projektierwerkzeuge zu integrieren. Insbesondere ist eine Kombination mit dem Prüfverfahren der WO 01/71880 A möglich.

## Patentansprüche

1. Verfahren zum Prüfen einer Anordnung elektrischer Geräte auf Selektivität für den Kurzschlussfall mittels eines Rechners,
- bei dem eine Beschreibung der Anordnung vorgegeben wird,
- bei dem gemäß der Beschreibung mindestens ein elektrischer Verbraucher (1) aus mindestens einem ersten Speisebaustein (2) über mindestens zwei zwischen dem ersten Speisebaustein (2) und dem Verbraucher (1) angeordnete, zueinander in Reihe geschaltete Schutzschalter (3) mit elektrischer Energie versorgt wird,
- bei dem für jeden Schutzschalter (3) eine Beschreibung für dessen Auslöseverhalten zumindest als Funktion des den jeweiligen Schutzschalter (3) durchfließenden Wechselstroms mit den zugehörigen Schwellwerten (SW) vorgegeben wird,
- bei dem anhand der Beschreibungen bei einer Anzahl von Stromwerten (I) geprüft wird, ob der näher am Verbraucher (1) angeordnete Schutzschalter (3) stets vor dem näher am Speisebaustein (2) angeordneten Schutzschalter(3) auslöst, und
- bei dem dazu bei Stromwerten (I) oberhalb des für einen vorbestimmten Schutzschalter (3) spezifischen Schwellwertes (SW) zunächst ein zeitlicher Verlauf des Stromwerts (I) und anhand des zeitlichen Verlaufs des Stromwerts (I) eine minimale und eine maximale Auslösezeit (tmin, tmax) für diesen Schutzschalter (3) ermittelt und zur Prüfung der Selektivität der Anordnung verwendet wird,
**dadurch gekennzeichnet,**
**dass** dass geprüft wird job die Stromwerte (I) des vorbestimmten und des anderen Schutzschalters (3) ihren Schwellwert (SW) überschreiten, für vorbestimmten Schutzschalter (3) bei der Ermittlung des zeitlichen Verlaufs des Stromwerts (I) eine innerhalb der Periodendauer (T) liegende Phasenlage (ϕ) berücksichtigt wird, die einem Zeitpunkt (t0) entspricht, ab dem der Stromwert (I) oberhalb des Schwellwerts (SW) liegt,
**dass** zumindest anhand einer Beschreibung des Speisebausteins (2) ein maximal möglicher zeitlicher Verlauf (Imax) des Stromwerts (I) mit der Phasenlage (ϕ) als Parameter und daraus der zeitliche Verlauf des Stromwerts (I) ermittelt wird,
**dass** ab dem Zeitpunkt (t0) anhand des ermittelten zeitlichen Verlaufs des Stromwerts (I) das zeitliche Integral über dem Quadrat des jeweils momentan gegebenen Stromwerts (I) ermittelt wird,
**dass** durch Vergleich des integrats mit einem Schutzschalter (3) spezifischen minimalen Grenzwert eine minimale Zeit (tmin (ϕ)) und durch Vergleich mit einem Schutzschalter (3) spezifischen maximalen Grenzwert eine maximale Zeit (tmax (ϕ)) jeweils mit der Phasenlage (ϕ) als Parameter bestimmt wird und dass daraus durch Addition der Zeit bis zu dem Zeitpunkt (t0) die minimale und die maximale Auslösezeit (tmin, tmax) berechnet werden.

2. Prüfverfahren nach Anspruch 1,
**dadurch gekennzeichnet,**
**dass** der zeitliche Verlauf des Stromwerts (I) vom Rechner unter Berücksichtigung der Beschreibung der Anordnung ermittelt wird.

3. Prüfverfahren nach Anspruch 1 bis 2,
**dadurch gekennzeichnet,**
**dass** der maximal mögliche zeitliche Verlauf (Imax) des Stromwerts (I) vom Rechner aufgrund einer Beschreibung des betrachteten Schutzschalters (3) auf den zeitlichen Verlauf des Stromwerts (I) reduziert wird.

4. Prüfverfahren nach einem der obigen Ansprüche,
**dadurch gekennzeichnet,**
**dass** gemäß der Beschreibung der Anordnung zwischen den Schutzschaltern (3) ein Knotenpunkt (16) angeordnet ist, über den ein zweiter Speisebaustein (15) angeschlossen ist, und dass die Stromwerte (I), bei denen der näher am Verbraucher (1) angeordnete Schutzschalter (3) geprüft wird, nur anteilig bei dem näher am Speisebaustein (2) angeordneten Schutzschalter(3) berücksichtigt werden.

5. Prüfverfahren nach einem der obigen Ansprüche,
**dadurch gekennzeichnet,**
**dass** die Beschreibungen des Auslöseverhaltens der Schutzschalter (3) dem Rechner durch Auswahl vordefinierter Beschreibungen vorgegeben werden.

6. Prüfverfahren nach einem der obigen Ansprüche,
**dadurch gekennzeichnet,**
**dass** der Rechner eine Meldung ausgibt, anhand derer erkennbar ist, ob der näher am Verbraucher (1) angeordnete Schutzschalter (3) bei jedem der überprüften Stromwerte (I) vor dem näher am Speisebaustein (2) angeordneten Schutzschalter (3) auslöst oder nicht.

7. Prüfverfahren nach Anspruch 6,
**dadurch gekennzeichnet,**
**dass**, wenn der näher am Verbraucher (1) angeordnete Schutzschalter (3) bei mindestens einem der überprüften Stromwerte (I) nicht vor dem näher am Speisebaustein (2) angeordneten Schutzschalter (3) auslöst, anhand der Meldung erkennbar ist, bei welchem minimalen Stromwert (I) dieser Fall eintritt, welcher Schutzschalter (3) der zuerst auslösende Schutzschalter (3) ist und/oder mit welcher Auslösezeit (tmin) diese Auslösung erfolgt.

## Claims

1. Method for testing an arrangement of electrical apparatuses for selectivity for the case of a short circuit by means of a computer,
- in which a description of the arrangement is predefined,
- in which, according to the description, at least one electrical load (1) is supplied with electrical energy from at least one first supply module (2) via at least two circuit breakers (3) which are arranged between the first supply module (2) and the load (1) and are connected in series with one another,
- in which, for each circuit breaker (3), a description of the tripping response of the latter is predefined at least as a function of the alternating current flowing through the respective circuit breaker (3) with the associated threshold values (SW),
- in which, for a number of current values (I), the descriptions are used to check whether the circuit breaker (3) arranged closer to the load (1) always trips before the circuit breaker (3) arranged closer to the supply module (2), and
- in which, in the case of current values (I) above the threshold value (SW) which is specific to a predetermined circuit breaker (3), a temporal profile of the current value (I) is first of all determined and, on the basis of the temporal profile of the current value (I), a minimum tripping time (tmin) and a maximum tripping time (tmax) are determined for this circuit breaker (3) and are used to test the selectivity of the arrangement, **characterized in that**
a check is carried out in order to determine whether the current values (I) of the predetermined circuit breaker (3) and of the other circuit breaker (3) exceed their threshold value (SW),
**in that** a phase angle (ϕ) which lies within the period duration (T) and corresponds to a point in time (t0) from which the current value (I) is above the threshold value (SW) is taken into account when determining the temporal profile of the current value (I) for the predetermined circuit breaker (3),
**in that** a maximum possible temporal profile (Imax) of the current value (I) with the phase angle (ϕ) as the parameter and, from this, the temporal profile of the current value (I) are determined at least using a description of the supply module (2),
**in that**, from the point in time (t0) on, the time integral over the square of the respective instantaneously given current value (I) is determined using the determined temporal profile of the current value (I),
**in that** a minimum time (tmin(ϕ)) is determined by comparing the integral with a minimum limit value specific to the circuit breaker (3) and a maximum time (tmax (ϕ) ) is determined by comparison with a maximum limit value specific to the circuit breaker (3), each with the phase angle (ϕ) as the parameter, and
**in that** the minimum tripping time (tmin) and the maximum tripping time (tmax) are calculated therefrom by adding the time to the point in time (t0).

2. Test method according to Claim 1,
**characterized in that**
the temporal profile of the current value (I) is determined by the computer taking into account the description of the arrangement.

3. Test method according to Claims 1 and 2,
**characterized in that**
the maximum possible temporal profile (Imax) of the current value (I) is reduced by the computer to the temporal profile of the current value (I) on the basis of a description of the circuit breaker (3) under consideration.

4. Test method according to one of the preceding claims,
**characterized in that**
according to the description of the arrangement, a node (16) is arranged between the circuit breakers (3) and is used to connect a second supply module (15), and
**in that** the current values (I) for which the circuit breaker (3) arranged closer to the load (1) is tested are taken into account only proportionally in the circuit breaker (3) arranged closer to the supply module (2).

5. Test method according to one of the preceding claims,
**characterized in that**
the descriptions of the tripping response of the circuit breakers (3) are predefined to the computer by selecting predefined descriptions.

6. Test method according to one of the preceding claims,
**characterized in that**
the computer outputs a message which can be used to discern whether or not the circuit breaker (3) arranged closer to the load (1) trips before the circuit breaker (3) arranged closer to the supply module (2) for each of the current values (I) which have been checked.

7. Test method according to Claim 6,
**characterized in that**
if the circuit breaker (3) arranged closer to the load (1) does not trip before the circuit breaker (3) arranged closer to the supply module (2) for at least one of the current values (I) which have been checked, the message can be used to discern the minimum current value (I) at which this situation occurs, which circuit breaker (3) is the circuit breaker (3) that trips first and/or the tripping time (tmin) with which this tripping process occurs.

## Revendications

1. Procédé de contrôle au moyen d'un ordinateur de la sélectivité en cas de court-circuit d'un agencement d'appareils électriques,
- dans lequel on donne à l'avance une description de l'agencement,
- dans lequel suivant la description on alimente en énergie électrique au moins un appareil ( 1 ) consommateur d'électricité à partir d'au moins un premier module ( 2 ) d'alimentation par au moins deux interrupteurs ( 3 ) de protection montés en série l'un par rapport à l'autre et disposés entre le premier module ( 2 ) d'alimentation et l'appareil ( 1 ) consommateur,
- dans lequel pour chaque interrupteur ( 3 ) de protection on donne à l'avance une description de son comportement de déclenchement au moins en fonction du courant alternatif passant dans l'interrupteur ( 3 ) de protection respectif avec les valeurs ( SW ) de seuil associées,
- dans lequel au moyen de la description on contrôle pour un certain nombre de valeurs ( I ) de courant si l'interrupteur ( 3 ) de protection monté le plus près de l'appareil ( 1 ) consommateur se déclenche toujours avant l'interrupteur ( 3 ) de protection monté le plus près du module ( 2 ) d'alimentation, et
- dans lequel pour cela on détermine, pour des valeurs ( I ) de courant supérieures à la valeur ( SW ) de seuil spécifique pour un interrupteur ( 3 ) de protection déterminé à l'avance, d'abord une courbe dans le temps de la valeur ( I ) de courant et, au moyen de la courbe dans le temps de la valeur ( I ) de courant, un temps ( tmin, tmax ) minimum et maximum de déclenchement de cet interrupteur ( 3 ) de protection et on l'utilise pour le contrôle de la sélectivité de l'agencement,
**caractérisé**
**en ce que** l'on contrôle si les valeurs ( I ) de courant de l'interrupteur ( 3 ) de courant déterminé à l'avance et de l'autre interrupteur ( 3 ) de courant dépassent sa valeur ( SW ) de seuil,
**en ce que**, pour l'interrupteur ( 3 ) de courant déterminé à l'avance, on tient compte, lors de la détermination de la courbe dans le temps de la valeur ( I ) de courant, d'une position ( ϕ ) en phase dans la période ( T ), position qui correspond à un instant ( t0 ) à partir duquel la valeur ( I ) de courant est supérieure à la valeur ( SW ) de seuil,
**en ce qu'**au moins au moyen d'une description du module ( 2 ) d'alimentation, on détermine une courbe ( Imax ) maximum possible dans le temps de la valeur ( I ) de courant avec la position ( ϕ ) en phase comme paramètre et on en détermine la courbe dans le temps de la valeur ( I ) de courant,
**en ce qu'**à partir de l'instant ( t0 ) on détermine, au moyen de la courbe dans le temps qui a été déterminée de la valeur ( I ) de courant, l'intégral dans le temps du carré de la valeur ( I ) de courant donnée instantanément, en ce que l'on détermine, par la position ( ϕ ) en phase comme paramètre, en comparant l'intégral à une valeur limite minimum spécifique à un interrupteur ( 3 ) de protection, un temps ( tmin( ϕ ) ) minimum et, en comparant à une valeur limite maximum spécifique à un interrupteur ( 3 ) de protection, un temps ( tmax ( ϕ ) ) maximum respectivement et
**en ce qu'**on en calcule, par addition du temps jusqu'à un temps ( t0 ), le temps ( tmin ) minimum de déclenchement et le temps ( tmax ) maximum de déclenchement.

2. Procédé de contrôle suivant la revendication 1,
**caractérisé**
**en ce que** l'on détermine la courbe dans le temps de la valeur ( I ) de courant par l'ordinateur en tenant compte de la description de l'agencement.

3. Procédé de contrôle suivant la revendication 1 ou 2,
**caractérisé**
**en ce que** la courbe ( Imax ) maximum possible dans le temps de la valeur ( I ) du courant est réduite par l'ordinateur, sur la base d'une description de l'interrupteur ( 3 ) de protection considéré, à la courbe dans le temps de la valeur ( I ) de courant.

4. Procédé de contrôle suivant l'une des revendications précédentes,
**caractérisé**
**en ce que** suivant la description de l'agencement il est monté entre les interrupteurs ( 3 ) de protection un point ( 16 ) nodal par lequel un deuxième module ( 15 ) d'alimentation est raccordé et
**en ce que** les valeurs ( I ) de courant pour lesquelles l'interrupteur ( 3 ) de protection monté le plus près de l'appareil ( 1 ) consommateur est contrôlé ne sont prises en compte qu'en partie pour l'interrupteur ( 3 ) de courant monté le plus près du module ( 2 ) d'alimentation.

5. Procédé de contrôle suivant l'une des revendications précédentes,
**caractérisé**
**en ce que** les descriptions du comportement de déclenchement des interrupteurs ( 3 ) de protection sont prescrites à l'ordinateur par un choix de descriptions définies à l'avance.

6. Procédé de contrôle suivant l'une des revendications précédentes,
**caractérisé**
**en ce que** l'ordinateur émet un message au moyen duquel on peut reconnaître si l'interrupteur ( 3 ) de protection monté le plus près de l'appareil ( 1 ) consommateur se déclenche ou ne se déclenche pas avant l'interrupteur ( 3 ) de protection monté le plus près du module ( 2 ) d'alimentation.

7. Procédé de contrôle suivant la revendication 6,
**caractérisé**
**en ce que**, lorsque l'interrupteur ( 3 ) de protection monté le plus près de l'appareil ( 1 ) consommateur ne se déclenche pas pour au moins l'une des valeurs ( I ) de courant contrôlé avant l'interrupteur ( 3 ) de protection monté le plus près du module ( 2 ) d'alimentation, il peut être reconnu au moyen du message à quelle valeur ( I ) de courant minimum ce cas se produit, quel interrupteur ( 3 ) de protection est l'interrupteur ( 3 ) de protection se déclenchant le premier et/ou à quel temps ( tmin ) de déclenchement ce déclenchement se produit.
